(19)

**Europäisches Patentamt**
**European Patent Office**
**Office européen des brevets**

(11) **EP 4 550 663 A1**

(12) **EUROPEAN PATENT APPLICATION**

(43) Date of publication:
**07.05.2025 Bulletin 2025/19**

(21) Application number: **24204136.6**

(22) Date of filing: **02.10.2024**

(51) International Patent Classification (IPC):
*H03F 1/48* (2006.01)     *H03F 1/56* (2006.01)
*H03F 3/195* (2006.01)    *H03G 3/30* (2006.01)
*H04L 25/02* (2006.01)    *H03H 7/38* (2006.01)

(52) Cooperative Patent Classification (CPC):
**H03F 3/195; H03F 1/48; H03F 1/565; H03G 3/3078;**
**H03H 7/383; H04L 25/0278;** H03F 2200/255;
H03F 2200/451

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **30.10.2023 US 202318498008**

(71) Applicant: **Avago Technologies International**
**Sales**
**Pte. Limited**
**Singapore 768923 (SG)**

(72) Inventors:
• **Li, Guansheng**
  **Irvine, 92602 (US)**
• **Han, Jerry Jifang**
  **Cupertino, 95014 (US)**
• **Zhang, Bo**
  **Irvine, 92618 (US)**
• **Cui, Delong**
  **Tustin, 92782 (US)**
• **Cao, Jun**
  **Irvine, 92620 (US)**

(74) Representative: **Bosch Jehle**
**Patentanwaltsgesellschaft mbH**
**Flüggenstraße 13**
**80639 München (DE)**

(54) **A DISTRIBUTED PROGRAMMABLE GAIN AMPLIFIER**

(57)     An amplifier includes a first transmission line (211) from a first terminal to a second terminal. The first transmission line (211) comprises a first characteristic impedance matched to a resistance (Rs) of a source from which a first signal is coupled to the second terminal. The amplifier includes a first resistor (R1) with a first resistance and a second resistor (R2) with a second resistance coupled between the second terminal and a third terminal. The first resistance and the second resistance are adjustable to match an input impedance at the second terminal to the first characteristic impedance and to tune a gain of a second signal at the third terminal over the first signal at the second terminal. The amplifier includes a second transmission line (212) from the third terminal to a third resistor (Rt) with a third resistance, the second transmission line (212) comprises a second characteristic impedance matched to the third resistance (Rt).

FIG. 2

EP 4 550 663 A1

**Description**

The present disclosure is directed to devices for high-speed electrical/optical communications.

Advancements of high-speed optical communication technology have driven the demands on high-speed Serializer/Deserializer (SerDes) and optical transceivers for facilitating the rapid and reliable transfer of data across both short and long distances through electrical and optical channels. Programmable Gain Amplifiers (PGAs) play an integral role in both SerDes and optical transceivers. They are used to amplify or attenuate the data signal before it is converted between its serial and parallel forms in a SerDes or before it is converted between its electrical and optical forms in an optical transceiver. PGAs take in high-speed signals that may vary significantly in amplitude and amplify/attenuate them to a constant amplitude that is amenable to sub-stream circuits to maintain signal integrity in the face of noise and signal loss, ensuring that data can be accurately transmitted and received.

As the technology advances beyond 100Gb/s PAM4 SerDes, existing PGA structures may be inadequate to achieve the required large bandwidth, gain range and linearity. Higher data rate requires larger signal bandwidth. At the same time, it also means larger loading circuits to PGAs for parallel processing, which makes large bandwidth more difficult to achieve for programmable gain. Gain at high frequency cannot be controlled as easily as low frequency by resistor and/or trans-conductance, because parasitic capacitance and inductance become dominant at high frequency. Linearity of the signal path would be degraded if the large input signal is not attenuated by PGA before reaching the first stage of active transistors, which might be saturated and pushed into the nonlinear region. Therefore, an improved PGA is desired for achieving all-in-one performance on large bandwidth, e.g., 55GHz or higher, wideband gain control, and excellent linearity.

According to an aspect, an apparatus is provided comprising:

> a first circuit comprising a first transmission line starting from a first terminal and terminating at a second terminal, the first terminal being coupled to a source to receive a first signal, the source being coupled to ground via a first resistor characterized by a first resistance, the first transmission line being characterized by a first impedance equal to the first resistance;
> a second circuit comprising at least a second resistor characterized by a second resistance and a third resistor characterized by a third resistance, the second resistor being coupled between the second terminal and ground, the third resistor being coupled between the second terminal and a third terminal, the second circuit being configured to transmit the first signal from the first terminal to the second terminal and provide a gain to a second signal at the third terminal over the first signal; and
> a third circuit comprising a second transmission line starting from the third terminal and terminating with a fourth resistor, the fourth resistor being grounded and characterized by a fourth resistance, the second transmission line being characterized by a second impedance equal to the fourth resistance.

Advantageously, the second transmission line comprises one or more inductor-capacitor segments coupled in series, wherein the each inductor in the one or more inductor-capacitor segments is arranged in series in the second transmission line and each capacitor of the one or more inductor-capacitor segments is arranged in parallel between the second transmission line and the ground to configure the second transmission line with an impedance-matched termination.

Advantageously, the third circuit is configured to have a third impedance for the second signal from the third terminal downstream, the third impedance being equal to the second impedance.

Advantageously, the second circuit is configured to have a fourth impedance for the first signal from the second terminal downstream, the fourth impedance being equal to a parallel combination of the second resistance and a sum of the third resistance plus the third impedance.

Advantageously, the second resistance and the third resistance are adjustable to set the fourth impedance equal to the first impedance to configure the first transmission line with an impedance-matched termination at the second terminal.

Advantageously, the first circuit is configured to have a fifth impedance for the first signal from the first terminal downstream, the fifth impedance being equal to the first impedance.

Advantageously, the first circuit is configured to transmit the first signal from the first terminal to the second terminal with a return loss of less than -10dB across a full bandwidth of 55GHz or higher.

Advantageously, the gain is based on a ratio of the second impedance over a sum of the second impedance and the third resistance.

Advantageously, the gain has a range of at least 11dB across a full bandwidth of 55GHz or higher.

Advantageously, the gain is approximately uniform within 2dB across a full bandwidth of 55GHz or higher.

Advantageously, the third resistor comprises an array of resistors with different resistances controlled by respective switches.

Advantageously, the switch comprises a transistor with a gate terminal coupled to a first terminal of a fifth resistor with a resistance greater than 100 KOhm, the fifth resistor having a second terminal coupled to a control signal.

Advantageously, the first transmission line comprises one or more inductor-capacitor segments coupled in series, wherein each inductor in the one or more inductor-capacitor segments is arranged in series in the first transmission line and each capacitor of the one or more inductor-capacitor segments is arranged in parallel between the first transmission line and the ground.

Advantageously, the apparatus further comprises at least a fourth circuit comprising a transistor coupled to the second transmission line to provide an output signal based on the second signal at the third terminal.

According to an aspect, an apparatus is provided comprising:

a first transmission line disposed from a first terminal to a second terminal, the first terminal being coupled to a source to receive a first signal, the source being coupled to ground via a first resistor characterized by a first resistance, the first transmission line being configured to transmit the first signal from the first terminal to the second terminal;

a second resistor characterized by a second resistance coupled between the second terminal and ground;

a third resistor characterized by a third resistance coupled between the second terminal and a third terminal, the second resistance and the third resistance being adjustable to configure the first transmission line with a first impedance-matched termination at the second terminal and to provide a second signal at the third terminal with a gain over the first signal at the second terminal;

a second transmission line disposed from the third terminal to a fourth resistor, the fourth resistor being coupled to the ground and characterized by a fourth resistance, the second transmission line being configured to have a second impedance-matched termination for transmitting the second signal.

Advantageously, the first transmission line comprises one or more inductor-capacitor segments with each inductor being arranged in series and each capacitor being arranged in parallel, the one or more inductor-capacitor segments being characterized by a first impedance that is equal to the first resistance.

Advantageously, the second transmission line comprises one or more inductor-capacitor segments with each inductor being arranged in series and each capacitor being arranged in parallel, the one or more inductor-capacitor segments being characterized by a second impedance that is equal to the fourth resistance.

Advantageously, the second transmission line is configured to have a third impedance for the second signal from the third terminal downstream, the third impedance being equal to the second impedance attributed to the second impedance-matched termination across a full bandwidth of 55GHz or higher.

Advantageously, the apparatus being configured to have a fourth impedance for the first signal from the second terminal downstream based on a parallel combination of the second resistance and a sum of the third resistance plus the third impedance, the fourth impedance being equal to the first impedance attributed to the first impedance-matched termination at the second terminal.

Advantageously, the gain is approximately uniform across a full bandwidth of 55GHz or higher and has a tunable range of at least 11dB based on a ratio of the second impedance over a sum of the second impedance and the third resistance, wherein the third resistance is adjustable, and the second impedance is equal to the fourth resistance.

BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.

Figure 1 is a schematic block diagram of a wideband gain amplifier according to some embodiments of the subject technology.

Figure 2 is a simplified circuit diagram of a distributed programmable gain amplifier according to an embodiment of the subject technology.

Figure 3 is a schematic plot of resistor-controlled gain across a full bandwidth based on the distributed programmable gain amplifier according to an embodiment of the subject technology.

Figure 4 is a simplified diagram showing an example of the variable resistor R2 for the distributed programmable gain amplifier according to an embodiment of the subject technology.

Figure 5 is a plot of multiple gain curves across a full bandwidth for certain settings of the distributed programmable gain amplifier according to some embodiments of the subject technology.

Figure 6 is a plot of multiple input return loss curves across a full bandwidth for the same settings of the distributed programmable gain amplifier according to some embodiments of the subject technology.

DETAILED DESCRIPTION OF THE INVENTION

The present disclosure is directed to devices for high-speed electrical/optical communications. In an embodiment, a wideband programmable gain amplifier is provided, including a distributed input network configured to set impedance-matched input coupling and impedance-matched termination to transmit signal with low return loss in large bandwidth. The apparatus also includes a resistor-based network embedded in the distributed input network to achieve programmable gain for the signal with a wide gain range and uniform gain tunning across the large bandwidth. It is important to note that there are other alternative embodiments as well.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the present invention is not intended to be limited to the embodiments presented, but is to be accorded the widest scope consistent with the principles and novel features disclosed herein.

In the following detailed description, numerous specific details are set forth in order to provide a more thorough understanding of the present invention. However, it will be apparent to one skilled in the art that the present invention may be practiced without necessarily being limited to these specific details. In other instances, well-known structures and devices are shown in block diagram form, rather than in detail, in order to avoid obscuring the present invention.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus configured as a wideband programmable gain amplifier. The apparatus also includes a first circuit. The first circuit may include a first transmission line starting from a first terminal and terminating at a second terminal, the first terminal being coupled to a source to receive a first signal, the source being coupled to ground via a first resistor characterized by a first resistance, the first transmission line being characterized by a first impedance being equal to the first resistance. The apparatus also includes a second circuit. The second circuit may include at least a second resistor characterized by a second resistance and a third resistor characterized by a third resistance, the second resistor being coupled between the second terminal and ground, the third resistor being coupled between the second terminal and a third terminal, the second circuit being configured to transmit the first signal from the first terminal to the second terminal and provide a gain to a second signal at the third terminal over the first signal. The apparatus also includes a third circuit. The third circuit may include a second transmission line starting from the third terminal and terminating with a fourth resistor, the fourth resistor being grounded and characterized by a fourth resistance, the second transmission line being characterized by a second impedance being equal to the fourth resistance.

Implementations may include one or more of the following features. The apparatus where the second transmission line includes one or more inductor-capacitor segments coupled in series, where the each inductor in the one or more inductor-capacitor segments is arranged in series in the second transmission line and each capacitor of the one or more inductor-capacitor segments is arranged in parallel between the second transmission line and the ground to configure the second transmission line with an impedance-matched termination. The third circuit is configured to have a third impedance for the second signal from the third terminal downstream, the third impedance being equal to the second impedance. The second circuit is configured to have a fourth impedance for the first signal from the second terminal downstream, the fourth impedance being equal to a parallel combination of the second resistance and a sum of the third resistance plus the third impedance. The second resistance and the third resistance are adjustable to set the fourth impedance equal to the first impedance to configure the first line with an impedance-matched termination at the second terminal. The first circuit is configured to have a fifth impedance for the first signal from the first terminal downstream, the fifth impedance being equal to the first impedance. The first circuit is configured to transmit the first signal from the first terminal to the second terminal with a return loss at least less than -10dB across a full bandwidth of 55GHz or higher. The gain is based on a ratio of the second impedance over a sum of the second impedance and the third resistance. The gain has a tunable range of at least 11dB across a full bandwidth of 55GHz or higher. The gain is approximately uniform within 2dB across a full bandwidth of 55GHz or higher. The third resistor may include an array of resistors with different resistances controlled by respective switches. The switch may include a transistor with a gate terminal coupled to a first terminal of a fifth resistor with a resistance greater than 100 Kohm, the fifth resistor having a second terminal coupled to a control signal. The first line may include one or more inductor-capacitor segments coupled in series, where each inductor in the one or more inductor-capacitor segments is arranged in series in the first line and each capacitor of the one or more inductor-capacitor segments is arranged in parallel between the first line and the ground. The apparatus may include at least a fourth circuit. The fourth circuit may include a transistor coupled to the second transmission line to provide an output signal based on the second signal at the third terminal.

Another general aspect includes a distributed programmable gain amplifier apparatus. The apparatus also includes a first transmission line disposed from a first terminal to a second terminal, the first terminal being coupled to a source to receive a first signal, the source being coupled to ground via a first resistor characterized by a first resistance, the first transmission line being configured to transmit the first signal from the first terminal to the second terminal. The apparatus also includes a second resistor characterized by a second resistance coupled between the second terminal and ground. The apparatus also includes a third resistor characterized by a third resistance coupled between the second terminal and a third terminal, the second resistance and the third resistance being adjustable to configure the first transmission line with a first impedance-matched termination at the second terminal and to provide a second signal at the third terminal with a gain over the first signal at the second terminal. The apparatus also includes a second transmission line disposed from the third terminal to a fourth resistor, the fourth resistor being coupled to the ground and characterized by a fourth resistance, the second transmission line being configured to have a second impedance-matched termination for transmitting the second signal.

Implementations may include one or more of the following features. The apparatus where the first transmission line may include one or more inductor-capacitor segments with each inductor being arranged in series and each capacitor being arranged in parallel, the one or more inductor-capacitor segments being characterized by a first impedance that is equal to the first resistance. The second transmission line may include one or more inductor-capacitor segments with each inductor being arranged in series and each capacitor being arranged in parallel, the one or more inductor-capacitor segments being characterized by a second impedance that is equal to the fourth resistance. The second transmission line is configured to have a third impedance for the second signal from the third terminal downstream, the third impedance being equal to the second impedance. The apparatus being configured to have a fourth impedance for the first signal from the second terminal downstream based on a product of the second resistance and a sum of the third resistance plus the third impedance dividing a sum of the second resistance plus the third resistance plus the third impedance, the fourth impedance being equal to the first impedance attributed to the first impedance-matched termination at the second terminal. The gain is approximately uniform across a full bandwidth of 55GHz or higher and has a tunable range of at least 11dB based on a ratio of the second impedance over a sum of the second impedance and the third resistance, where the third resistance is adjustable, and the second impedance is equal to the fourth resistance.

In modem communication networks, high-speed Serializer/Deserializer (SerDes) and optical transceivers are often used for facilitating the rapid and reliable transfer of data across both short and long distances. Programmable Gain Amplifiers (PGAs) can be used to amplify the input signal before serialization, ensuring that it can be accurately received and deserialized at the other end. PGAs can be used in both the transmitting and receiving ends. On the transmitter side, a PGA can amplify the electrical signal before it is converted into an optical signal, ensuring that it can travel longer distances. On the receiver side, a PGA can amplify the received signal before it is converted back into an electrical signal, ensuring that it can be accurately interpreted.

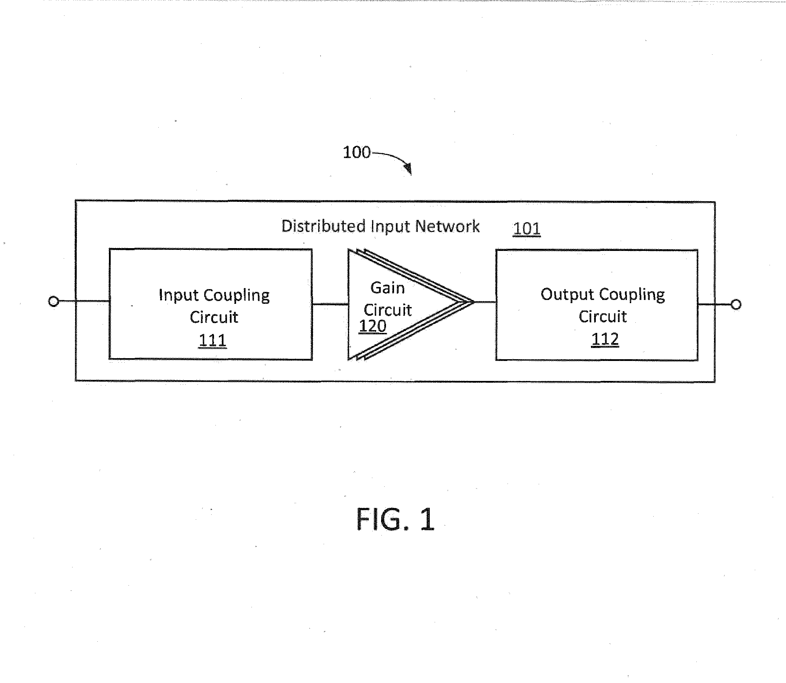

As higher (>100Gb/s) data rates are demanded in the high-speed communication systems, the existing PGA design does not provide satisfactory performance with large bandwidth, wideband gain control and excellent linearity at the same time. FIG. 1 shows a simplified block diagram of a wideband gain amplifier according to some embodiments of the subject technology. The wideband programmable gain amplifier 100 is configured with a distributed input network 101 to artificially divide the input signal and distribute to multiple gain stages. At each gain stage, the divided input signal can be individually adjusted, and collectively all gain stages cover a broader frequency range. In an alternative view, the distributed input network 101 can be configured to optimize the interface between a signal source and a gain circuit 120 (e.g., representing a gain stage) via an input coupling circuit 111, as well as the gain circuit 120 and an output coupling circuit 112 for the subsequent stages or loads.

In an embodiment, the distributed input network 101 designed for the gain amplifier may use an artificial transmission line, usually made up of cascaded inductors and capacitors, to handle the signal amplification/attenuation by emulating ideal transmission line characteristics. In general, an artificial transmission line in the context of subject technology refers to a structured network of passive components, typically inductors and capacitors, arranged in a way that emulates the electrical properties and behavior of a traditional transmission line. Unlike natural transmission lines, these artificial constructs allow designers to fine-tune specific electrical characteristics, providing greater control over signal integrity, impedance characteristics, and other critical parameters. The artificial transmission line can be implemented as a series of cascaded inductor-capacitor (LC) segments or other topologies to achieve the desired transmission line characteristics may have multiple sections. In each segment, an input coupling circuit 111 is situated at the start of the artificial transmission line, responsible for matching the impedance of the signal source to the artificial transmission line. The output coupling circuit 112 is located at the end of the artificial transmission line of the distributed network, performing the reverse function of the input coupling, matching the transmission line's impedance to the load or the next stage. A gain circuit 120, representing at least one of the multiple gain stages distributed along the artificial transmission line, is disposed between the input coupling circuit 111 and the output coupling circuit 112, responsible for the amplification/attenuation of the signal as it traverses the line. The input coupling circuit 111 and the output coupling circuit 112 may include a range of reactive and resistive components, e.g., usually made up of cascaded inductors and capacitors, to minimize reflections and maximize power transfer. The gain circuit 120 may include components such as switches, variable capacitors, or variable resistors to adjust the properties of the artificial transmission line and apply a gain or attenuation to the signal as it traverses the stage. Additionally, the gain circuit 120 may cause the gain or attenuation to be programmable and achieve linear performance over a wide frequency range.

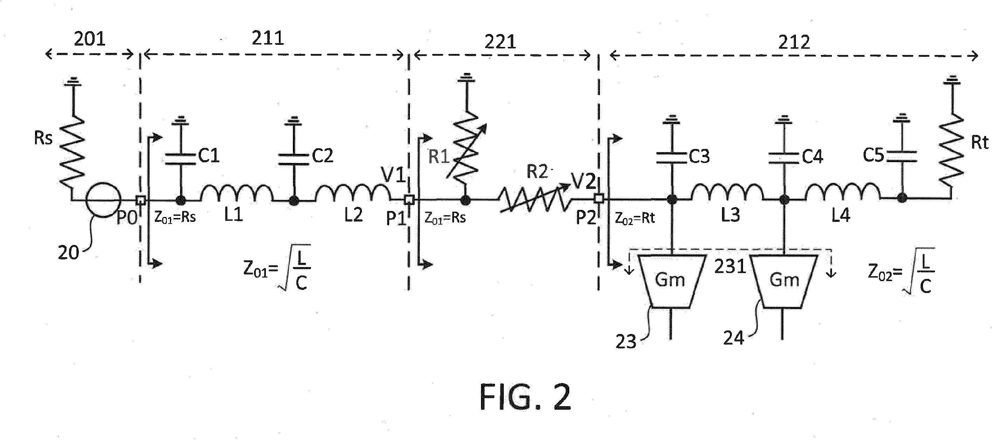

Figure 2 is a simplified circuit diagram of a distributed programmable gain amplifier according to an embodiment of the subject technology. This diagram is merely an example, which should not unduly limit the scope of the claims. One of ordinary skill in the art would recognize many variations, alternatives, and modifications. In a specific embodiment, a distributed gain amplifier is provided by implementing a distributed input network for achieving large bandwidth and an embedded resistor network for achieving flexible gain adjustment mechanism and linear performance over a wide frequency range. As shown in FIG. 2, the distributed input network is made up of one artificial transmission line configured to couple to a signal source 20 at an input stage 201 to receive an input signal with minimum loss and generate an output signal with a desired gain/attenuation to an output stage 231 with minimum gain variation across the full bandwidth. This input signal may be a single-ended signal. In an alternative case, another artificial transmission line may be added for handling a differential input signal, in which one artificial transmission line is configured to receive and process an input signal with positive polarity while another artificial transmission line, maybe configured the same, is configured to receive and process another input signal with negative polarity.

Referring to the circuitry in FIG. 2, the one artificial transmission line of the distributed gain amplifier is a first transmission line 211 (also referred as a first circuit) starting from a first terminal P0 and terminating at a second terminal P1. The first terminal P0 is directly coupled to the signal source 20 to receive a first signal V1. The signal source may be terminated to ground via a resistor having a resistance Rs. The first circuit 211 is configured to allow an input signal from the signal source 20 to be transmitted from the first terminal P0 to the second terminal P1. The distributed gain amplifier also includes a second circuit 221 sequentially coupled between the second terminal P1 and a third terminal P2. The distributed gain amplifier further includes another artificial transmission line, a second transmission line 212 (also referred as a third circuit), 'starting from the third terminal P2 and terminating to ground via a resistor having a resistance Rt. The second circuit 221 and the third circuit 212 are configured to adjust the properties of the artificial transmission line and provide a gain to a second signal V2 at the third terminal P2 under a control of the artificial transmission line. The output stage 231, in an embodiment, includes at least a fourth circuit 23 coupled to the second transmission line 212 to deliver an output signal based on the second signal V2. The fourth circuit 23 is based on transistors. In another embodiment, the output stage 231 also includes a fifth circuit 24. The fourth circuit 23 and the fifth circuit 24 are coupled respectively to two segments of the third circuit 212 to deliver the output signal based on the second signal V2.

In a specific embodiment, the first transmission line 211, the first circuit of the amplifier, is represented by a series of inductor-capacitor (LC) segments being cascaded in a chain with all inductors being serially connected in a line from the first terminal P0 to the second terminal P1 and all capacitors being parallelly coupled from respective intersections on the line of the inductors to the ground. The L and C represent inductors and capacitors, respectively. The series of inductor-capacitor (LC) segments is used to simulate the parasitic capacitance in the input transmission line coupled to the signal source and use these inductors with respective inductance to separate the parasitic capacitance to individual (small) capacitors and can be arranged with an arbitrary number of LC segments depending on the design choice based on actual signal transmission characteristics. The series of segments of inductor-capacitor (LC) segments can be characterized by a first characteristic impedance $Z_{01}$ given by,

$$Z_{01} = \sqrt{\frac{L}{C}} \qquad\qquad (1)$$

to represent an impedance of a lossless transmission line where L is inductance per unit length or per segment and C is capacitance per unit length or per segment. Referring to FIG. 2, an example of the first transmission line 211 comprises at least a first LC segment. Optionally, the first transmission line 211 also includes a second LC segment. The first LC segment includes a first inductor L1 and a first capacitor C 1. The second LC segment includes a second inductor L2 and a second capacitor C2. L2 is coupled to L1 in series in the transmission line. C2 and C1 are in parallelly arranged between the transmission line and the ground. Optionally, there are more LC segments arranged or cascaded in similar way as the first two segments. Each inductor is arranged in series with other inductors and each capacitor is arranged in parallel with other capacitors. In an embodiment, the first transmission line 211 is configured, by choosing proper values for the inductors and capacitors in the series of LC segments, to allow the input signal from the signal source 20 being coupled to the first signal V1 at the second terminal with maximum power transfer or minimum return loss as the signal traverses through the artificial transmission line. This can be achieved if the first transmission line 211 is configured to have an impedance-matched termination.

A transmission line with an impedance-matched termination refers to a propagation medium, be it coaxial cable, microstrip line, or any other form, that concludes in a load or termination whose impedance is coordinated with the inherent characteristic impedance $Z_0$ of the transmission line itself. For a transmission line disposed from a starting terminal which is coupled to a signal source (or from which a signal is received) to an ending terminal which is coupled to a load (or from which the signal is outputted downstream), it can be configured to have impedance-matched terminations at both the starting terminal and the ending terminal. In FIG. 2, the source 20 is terminated by a resistor Rs. The source impedance in such a model can be represented primarily by the resistance of that resistor, i.e., source impedance is primarily source resistance. At higher frequencies, even a simple resistor can introduce some parasitic inductance or capacitance due to its physical construction or layout on a circuit board. These parasitic elements, in the embodiment, can be included in the first transmission line 211 (or the first circuit). The transmission line 211 can be characterized by the first characteristic impedance $Z_{01}$ depending on the topology configuration of the LC segments therein. If the first characteristic impedance $Z_{01}$ is equal to Rs, an impedance-matched condition is achieved at the starting terminal P0. On the ending terminal, if the characteristic impedance of the transmission line is equal to a load impedance at the ending terminal, which is the impedance seen by a signal transmitting from the ending terminal downstream, the transmission line is considered an impedance-matched termination at the ending terminal. For example, in FIG. 2, an impedance for a signal from the second terminal P2 downstream corresponds to a load impedance seen by the signal from all circuit elements from the terminal P2 downstream - all resistors, inductors, and capacitors in respective circuitry structure of the second circuit 221 and third circuit 212.

In some implementations, the second transmission line 212, or the third circuit of the amplifier, also can be represented by a series of LC segments in similar configurations and, more specifically, be terminated by a resistor Rt. In the example shown in FIG. 2, the second transmission line 212 comprises a third LC segment and a fourth LC segment coupled serially in a line from the third terminal P2 to the termination resistor Rt. The third LC segment includes a third inductor L3 and a third capacitor C3. The fourth LC segment includes a fourth inductor L4 and a fourth capacitor C4. The termination resistor Rt is coupled to the ground, which may be accompanied by capacitor C5 coupled in parallel from the line to the ground. Capacitor C3, C4, C5 represent the parasitic capacitance of other circuit devices. Optionally, the second transmission line 212 includes only one LC segment terminated by the combination of C5 and Rt. Optionally, there are more LC segments arranged or cascaded in a similar way as the first two segments. Each inductor is arranged in series with other inductors and each capacitor is arranged in parallel with other capacitors. In the example shown in FIG. 2, the second transmission line 212 is characterized by a second characteristic impedance $Z_{02}$ which is dependent on design choices of the number of LC segments and inductance/capacitance values thereof. The termination resistor Rt allows the second transmission line 212 to be configured to allow the artificial transmission line of C3-L3-C4-L4-C5 to have an impedance-matched termination so that $Rt = Z_{02}$. Because of the impedance-matched termination, an impedance seen by a signal transmitting from the third terminal P2 downstream is always equal to the second characteristic impedance $Z_{02}$ due to the impedance-matched termination. In an embodiment, the impedance-matched termination condition associated with the second transmission line 212 is configured to be valid for a wide frequency range. For example, one design under the present disclosure has a broad bandwidth, e.g. 55GHz or higher. A higher frequency range is possible.

The second circuit 221 is made up by at least a first resistor R1 and a second resistor R2 disposed between the first transmission line 211 and the second transmission line 212. The first resistor R1, a variable resistor, is coupled between the second terminal P1 and the ground. The second resistor R2, also a variable resistor, is coupled between the second terminal P1 and the third terminal P2. The second circuit 221 is configured to be a gain circuit of the amplifier, acting as a gain stage disposed in the artificial transmission line to provide a second signal V2 at the third terminal P2 with a tunable gain over the first signal V1 at the second terminal P1. Both R1 and R2 are variable, providing a flexible manner to achieve gain control with substantially frequency-independent mechanism across a wide frequency range.

Given that the second transmission line 212 is coupled to the second resistor R2 in series, they form a resistive divider of the signal traversing the second circuit 221. Therefore, a gain is provided as:

$$V2/V1 = Z_{02}/(R2 + Z_{02}) \qquad\qquad (2)$$

which is tunable by adjusting R2. Since the input impedance of the second transmission line at the third terminal is also the same as the impedance (for the second signal V2) from the third terminal P2 downstream to its termination. Additionally, the second characteristic impedance $Z_{02}$ is equal to the termination resistance Rt. Therefore, the gain is essentially independent from the frequency of the signal but tunable by varying resistance R2. This tunable mechanism for the gain also provides a programmable gain range. The lower end of the gain range can be expanded somewhat indefinitely, but the higher end of the gain range is limited by parasitic resistance in the signal path. Depending on the specific design choices for the artificial transmission line for the distributed gain amplifier according to the subject technology, $Z_{02} = Rt$ can be achieved at least for a full bandwidth up to a very high frequency, e.g., 55GHz or higher. This bandwidth of interest is primarily limited by the associated capacitances in the artificial transmission line and may be extended by dividing them into smaller ones.

In a specific embodiment, the design choice of the second circuit 221 also is interrelated to the design of the first circuit 211 to configure the first transmission line with an impedance-matched termination at the second terminal P1. In particular, an impedance (for a signal) from the second terminal P1 toward the third terminal P2 and the second transmission line 212 can be expressed by a parallel combination of the first resistance R1 and a summation of the second resistance R2 with the impedance of the second transmission line $Z_{02}$, $R1\|(R2 + Z_{02})$. The design choices of both the second circuit 221 (via the variable resistor R1 and R2) and the first circuit 211 (via the plurality of LC segments) are set to make the impedance from the second terminal P2 downstream equal to the first characteristic impedance,

$$R1\|(R2 + Z_{02}) = Z_{01} \qquad\qquad (3)$$

This makes the first transmission line with an impedance-matched termination at the second terminal P2, i.e., the impedance from the second terminal P1 downstream is equal to the first characteristic impedance of the first transmission line 211. Attributed to the impedance-matched termination of the first transmission line, an impedance (for the first signal V1) from the first terminal P0 downstream, should be equal to the first characteristic impedance $Z_{01}$. By choosing proper values for the inductors and capacitors in the chain of LC segments of the first transmission line 211, the first characteristic impedance $Z_{01}$ can be equal to the source resistance Rs, $Z_{01}$ = Rs. Thus, the input impedance of the first transmission line 211 at the first terminal P0 must also equal to the source resistance Rs. Under the impedance-matched conditions at both the starting terminal P0 and the ending terminal P1 of the first transmission line 211, an excellent minimum reflection is achieved for the signals to transmit through the first transmission line 211. The input signal, the first signal V1, received from the source 20 can be coupled from the first terminal P0 to the second terminal P1 with minimum (essentially zero) return loss.

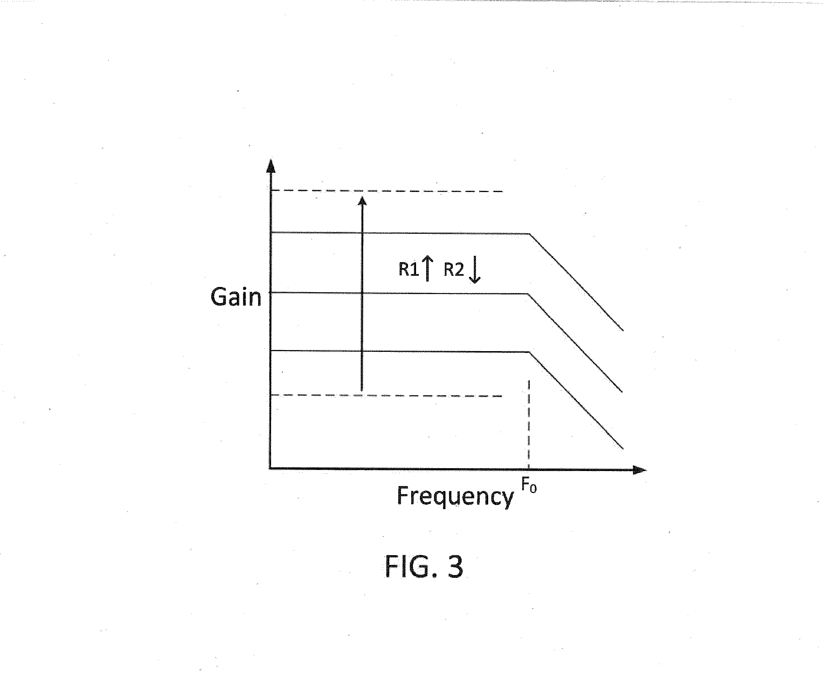

Figure 3 is a schematic plot of resistor-controlled gain across a full bandwidth based on the distributed programmable gain amplifier according to an embodiment of the subject technology. This diagram is merely an example, which should not unduly limit the scope of the claims. One of ordinary skill in the art would recognize many variations, alternatives, and modifications. A schematic plot of the gain of the amplifier disclosed in FIG. 2 shows that it is tunable by adjusting two resistors R1 and R2. When the first resistance R1 increases and the second resistance R2 decreases, the gain value increases while the input resistance and matching of the first transmission line are maintained. The gain range is explicitly dependent on the variable resistances of R1 and R2 and also explicitly limited by the parasitic resistance in the signal path. It also shows that the gain at each level is substantially uniform against the frequency, at least for the frequency of interest from low to high up to $F_0$. $F_0$ may be used to characterize the operation bandwidth of the amplifier. As it is described in earlier paragraphs, the gain is primarily dependent on a resistor network built on the first resistor R1, the second resistor R2, and the termination resistor Rt. Since the second characteristic impedance $Z_{02}$ is equal to Rt over a wide frequency range, the gain is essentially frequency independent. FIG. 3 shows that the present disclosure of the amplifier in FIG. 2 is capable to achieve that limitation by pushing the value $F_0$ to 55 GHz or higher before we notice the tailing down.

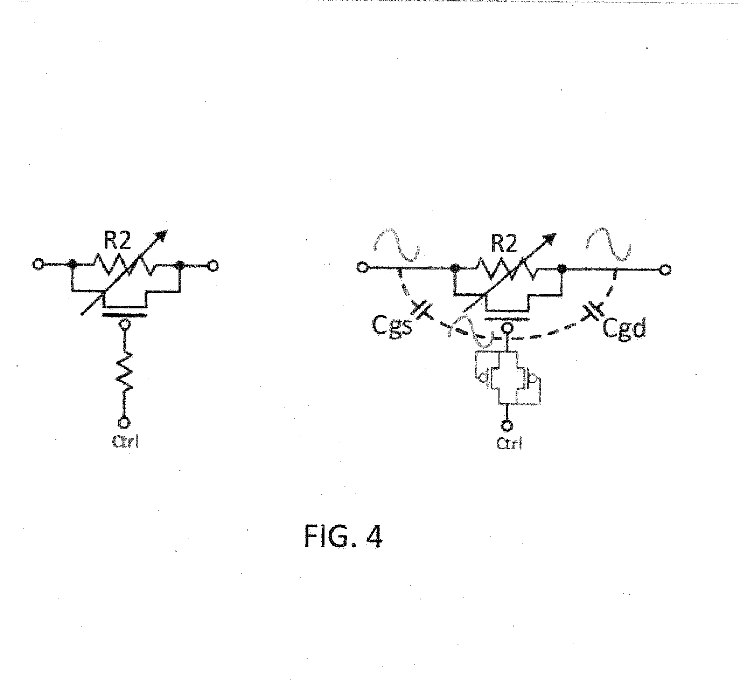

In some embodiments, the first resistor R1 and the second resistor R2 can be tunable by configuring each of them as a switched resistor array. For example, R1 or R2 includes a plurality of resistors with increasing resistances, wherein each resistor is controlled by a switch that can turn it On or Off to allow the resistance of R1 or R2 to be tuned. FIG. 4 is a simplified diagram showing an example of the variable resistor R2 for the distributed programmable gain amplifier according to an embodiment of the subject technology. The switch for controlling the resistor (R2) is a transistor with its source and drain respectively coupled to two terminals of the resistor in the array. The gate of the transistor is coupled to a control signal (Ctrl) through a resistor having a large resistance (e.g., 100 KOhm or higher). The large gate resistance is used so that the gate voltage applied for controlling the On or Off state of the transistor can follow the input signal in the transmission line. As shown in FIG. 4, the variable resistor R2 controlled by the large gate resistor at the left of the figure is equivalent to a circuitry at the right of the figure. In this transistor configuration, gate-to-source voltage Vgs and gate-to-drain voltage Vgd must not be modulated by the input signal so that the switch resistance is linear and does not distort the input signal. At the same time, parasitic capacitance between the gate and source, Cgs, and parasitic capacitance between the gate and drain, Cgd, do not load in the signal path to cause the gain change. Thus, the gain, within a certain tunable range, can be kept uniform for a large bandwidth. In another embodiment, as shown in the right part of FIG. 4, the function of the large gate resistor can be interpreted as a pair of diodes connected to the gate terminal of the transistor. Leakage current keeps source/drain/gate at a same DC voltage level, and the diode at "Off' state behaves like a super large resistor. One of the pair of diodes turns On briefly when a control signal "Ctrl" toggles, providing fast switching preferred for tuning the gain. In general, these tunable resistors R1 or R2 can be made in a small footprint with compact layout, which leads to small parasitic capacitance in the transmission line for achieving high impedance. The control signal "Ctrl" can be provided by a controller which is programmable to provide programmable gain for the wideband amplifier across a wide frequency range.

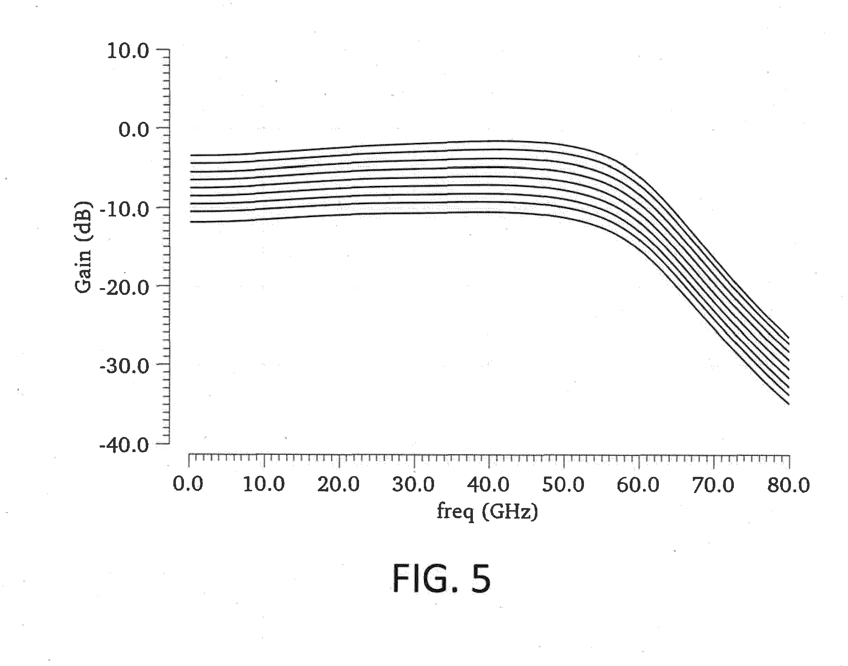

Figure 5 is a plot of multiple gain curves across full bandwidth for certain settings of the distributed programmable gain amplifier according to some embodiments of the subject technology. This diagram is merely an example, which should not unduly limit the scope of the claims. One of ordinary skill in the art would recognize many variations, alternatives, and modifications. FIG. 5 shows a plot of multiple gain curves across full bandwidth based on certain optimized settings of the distributed programmable gain amplifier shown in FIG. 2. The parasitic capacitance in the first transmission line is divided to a first capacitor C1 = 30 fF and a second capacitor C2 = 60 fF by two inductors L1 and L2. By choosing proper inductance values for L1 and L2, a first characteristic impedance $Z_{01}$ is matched to the source resistance Rs. The parasitic capacitance in the second transmission line is divided to a third capacitor C3 = 100 fF, a fourth capacitor C4 = 100 fF, and a fifth capacitor C5 = 30 fF by two inductors L3 and L4. By choosing proper inductance values for L3 and L4 and a termination resistor Rt, a second characteristic impedance $Z_{02}$ is matched to the termination resistance Rt.

As a result of the impedance matching design for both the first transmission line and the second transmission line, the gain circuit between these transmission lines can be configured to tune the amplifier gain based on R1/(R2+Rt), where Rt = $Z_{02}$. The gain, as shown in FIG. 5, is shown to be approximately independent from the frequency. Approximate uniform gain control is achieved with a gain variation just smaller than 2dB across the full bandwidth of 55 GHz or higher. This demonstrates that the distributed gain amplifier has a large bandwidth to meet the demands in modern high-speed communication systems. By changing the resistance of R1 or E2, the gain is programmable and can be varied in a large range of at least greater than 11 dB, as shown in FIG. 5. The lower end of the gain range can be expanded somewhat indefinitely, but the higher end of the gain range is limited by parasitic resistance in the signal path.

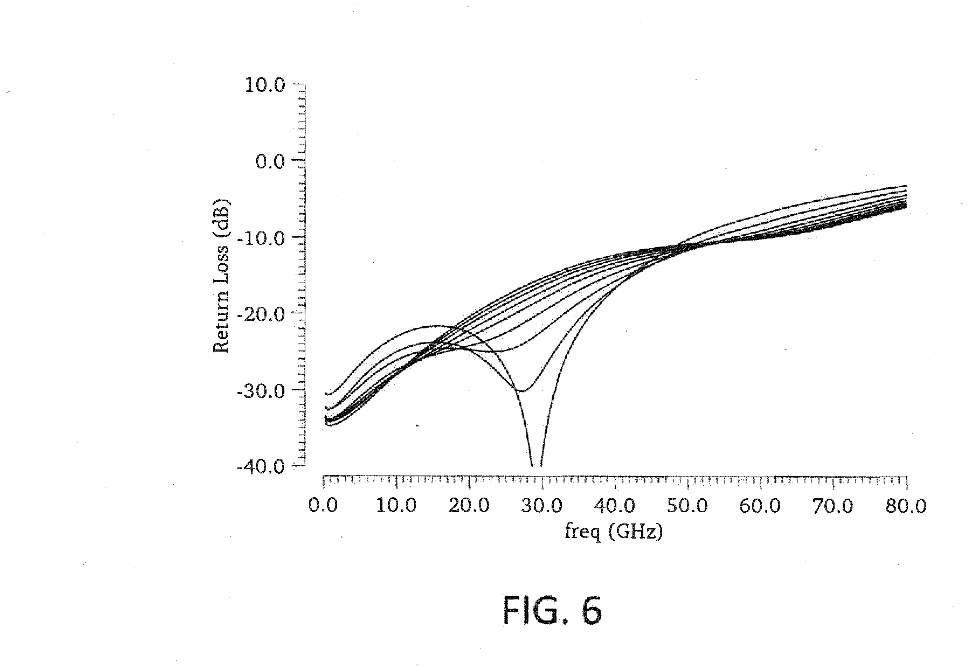

Figure 6 is a plot of multiple input return loss curves over full bandwidth for the same settings of the distributed programmable gain amplifier according to some embodiments of the subject technology. This diagram is merely an example, which should not unduly limit the scope of the claims. One of ordinary skill in the art would recognize many variations, alternatives, and modifications. FIG. 6 shows a plot of multiple input return loss curves over the full bandwidth for the same settings as those in FIG. 5 for the distributed programmable gain amplifier shown in FIG. 2. The parasitic capacitance in the first transmission line is divided to a first capacitor C 1 = 30 fF and a second capacitor C2 = 60 fF by two inductors L1 and L2. By choosing proper inductance values for L1 and L2, a first characteristic impedance $Z_{01}$ is matched to the source resistance Rs. The input impedance of the first transmission line is equal to the first characteristic impedance $Z_{01}$ due to a matched termination at the second terminal, giving an excellent condition for inducing a minimum return loss for the signal traversing the first transmission line. As shown in FIG. 6, the return loss is smaller than -10 dB for the full bandwidth (55 GHz or higher in this example). Higher frequency also can be achieved within the same scope of the subject technology. This allows the input signal can be coupled to the gain stage with maximum power transfer.

In some embodiments, the distributed input network used in the example shown in FIG. 2 can be extended to have arbitrary number of inductor-capacitor-(or resistor) segments. The transmission line by the design of FIG. 2 can be implemented in single-ended as well as in differential circuits. The components that are used for building the artificial transmission line may be implemented in many forms and processes. For example, they can be provided as discrete devices (capacitor, inductor, or resistor) on a printed circuit board (PCB). Alternatively, they can also be provided as integrated devices in CMOS processes. In some embodiments, the resistor network associated with the second circuit and the third circuit can be implemented in different processes including sliding rheostat in discrete implementation, switched resistor array in CMOS processes, and voltage-controlled resistors. The wideband gain programmability of the distributed gain amplifier enables SerDes to cope with a large range of operation environments such as >200 Gb/s SerDes transceivers and high-speed switch applications.

While the above is a full description of the specific embodiments, various modifications, alternative constructions and equivalents may be used. Therefore, the above description and illustrations should not be taken as limiting the scope of the present invention, which is defined by the appended claims.

**Claims**

1. An apparatus comprising:

a first circuit comprising a first transmission line starting from a first terminal and terminating at a second terminal, the first terminal being coupled to a source to receive a first signal, the source being coupled to ground via a first resistor **characterized by** a first resistance, the first transmission line being **characterized by** a first impedance equal to the first resistance;

a second circuit comprising at least a second resistor **characterized by** a second resistance and a third resistor **characterized by** a third resistance, the second resistor being coupled between the second terminal and ground, the third resistor being coupled between the second terminal and a third terminal, the second circuit being configured to transmit the first signal from the first terminal to the second terminal and provide a gain to a second signal at the third terminal over the first signal; and

a third circuit comprising a second transmission line starting from the third terminal and terminating with a fourth resistor, the fourth resistor being grounded and **characterized by** a fourth resistance, the second transmission line being **characterized by** a second impedance equal to the fourth resistance.

2. The apparatus of claim 1, wherein the second transmission line comprises one or more inductor-capacitor segments coupled in series, wherein the each inductor in the one or more inductor-capacitor segments is arranged in series in the second transmission line and each capacitor of the one or more inductor-capacitor segments is arranged in parallel between the second transmission line and the ground to configure the second transmission line with an impedance-matched termination.

3. The apparatus of claim 1 or 2, wherein the third circuit is configured to have a third impedance for the second signal from the third terminal downstream, the third impedance being equal to the second impedance.

4. The apparatus of claim 3, wherein the second circuit is configured to have a fourth impedance for the first signal from the second terminal downstream, the fourth impedance being equal to a parallel combination of the second resistance and a sum of the third resistance plus the third impedance.

5. The apparatus of claim 4, wherein the second resistance and the third resistance are adjustable to set the fourth impedance equal to the first impedance to configure the first transmission line with an impedance-matched termination at the second terminal.

6. The apparatus of any preceding claim, wherein the first circuit is configured to have a fifth impedance for the first signal from the first terminal downstream, the fifth impedance being equal to the first impedance.

7. The apparatus of any preceding claim, wherein the first circuit is configured to transmit the first signal from the first terminal to the second terminal with a return loss of less than -10dB across a full bandwidth of 55GHz or higher.

8. The apparatus of any preceding claim, wherein the gain is based on a ratio of the second impedance over a sum of the second impedance and the third resistance.

9. The apparatus of any preceding claim, wherein the gain has a range of at least 11dB across a full bandwidth of 55GHz or higher.

10. The apparatus of any preceding claim, wherein the gain is approximately uniform within 2dB across a full bandwidth of 55GHz or higher.

11. The apparatus of any preceding claim, wherein the third resistor comprises an array of resistors with different resistances controlled by respective switches.

12. The apparatus of any preceding claim, wherein the first transmission line comprises one or more inductor-capacitor segments coupled in series, wherein each inductor in the one or more inductor-capacitor segments is arranged in series in the first transmission line and each capacitor of the one or more inductor-capacitor segments is arranged in parallel between the first transmission line and the ground.

13. The apparatus of any preceding claim, further comprising at least a fourth circuit comprising a transistor coupled to the second transmission line to provide an output signal based on the second signal at the third terminal.

14. An apparatus comprising:

a first transmission line disposed from a first terminal to a second terminal, the first terminal being coupled to a source to receive a first signal, the source being coupled to ground via a first resistor **characterized by** a first resistance, the first transmission line being configured to transmit the first signal from the first terminal to the second terminal;
a second resistor **characterized by** a second resistance coupled between the second terminal and ground;
a third resistor **characterized by** a third resistance coupled between the second terminal and a third terminal, the second resistance and the third resistance being adjustable to configure the first transmission line with a first impedance-matched termination at the second terminal and to provide a second signal at the third terminal with a gain over the first signal at the second terminal;
a second transmission line disposed from the third terminal to a fourth resistor, the fourth resistor being coupled to the ground and **characterized by** a fourth resistance, the second transmission line being configured to have a second impedance-matched termination for transmitting the second signal.

15. The apparatus of claim 14, wherein the first transmission line comprises one or more inductor-capacitor segments with each inductor being arranged in series and each capacitor being arranged in parallel, the one or more inductor-capacitor segments being **characterized by** a first impedance that is equal to the first resistance.

100—

Distributed Input Network    101

Input Coupling
Circuit
111

Gain
Circuit
120

Output Coupling
Circuit
112

FIG. 1

FIG. 2

FIG. 3

FIG. 4

FIG. 5

EP 4 550 663 A1

FIG. 6

**EP 4 550 663 A1**

Europäisches Patentamt

European Patent Office

Office européen des brevets

# EUROPEAN SEARCH REPORT

Application Number

EP 24 20 4136

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 862 521 B1 (RAVIPRAKASH KARTHIK [US] ET AL) 8 December 2020 (2020-12-08) * column 1, line 26 - column 9, line 27; figures 1-10 * | 1-15 | INV. H03F1/48 H03F1/56 H03F3/195 H03G3/30 H04L25/02 H03H7/38 |
| A | US 2023/327623 A1 (LI GUANSHENG [US] ET AL) 12 October 2023 (2023-10-12) * paragraphs [0002] - [0060]; figures 1-6 * | 1-15 | |
| A | US 2021/297293 A1 (LEE CHULKYU [US] ET AL) 23 September 2021 (2021-09-23) * paragraphs [0002] - [0129]; figures 1-18 * | 1-15 | |

|  |  |  | TECHNICAL FIELDS SEARCHED (IPC) |
|---|---|---|---|
|  |  |  | H03F H04L H03G H03H |

The present search report has been drawn up for all claims

| Place of search | Date of completion of the search | Examiner |
|---|---|---|
| The Hague | 17 March 2025 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 4136

This annex lists the patent family members relating to the patent documents cited in  the above-mentioned European search report.
The members are as contained in the European Patent Office EDP file on
The European Patent Office is in no way liable for these particulars which are merely given for the purpose of information.

17-03-2025

| Patent document cited in search report | | Publication date | Patent family member(s) | | Publication date |
|---|---|---|---|---|---|
| US 10862521 | B1 | 08-12-2020 | NONE | | |
| US 2023327623 | A1 | 12-10-2023 | CN | 116896342 A | 17-10-2023 |
| | | | DE | 102023001349 A1 | 19-10-2023 |
| | | | US | 2023327623 A1 | 12-10-2023 |
| US 2021297293 | A1 | 23-09-2021 | BR | 112022018042 A2 | 18-10-2022 |
| | | | CN | 115280295 A | 01-11-2022 |
| | | | EP | 4121863 A1 | 25-01-2023 |
| | | | KR | 20220154681 A | 22-11-2022 |
| | | | US | 2021297293 A1 | 23-09-2021 |
| | | | WO | 2021188724 A1 | 23-09-2021 |

EPO FORM P0459

For more details about this annex : see Official Journal of the European Patent Office, No. 12/82